# EUROPEAN PATENT SPECIFICATION

(11) **EP 0 658 808 B1**
(45) Date of publication and mention of the grant of the patent: **17.03.1999**
(21) Application number: 93203569.4
(22) Date of filing: 17.12.1993
(51) Int. Cl.: G03F 7/07, G03C 8/06

(54) **Imaging element and method for making lithographic printing plates according to the silver salt diffusion transfer process**
Bildelement und Verfahren zur Herstellung lithographischen Druckplatten durch das Silbersalz-Diffusionübertragungsverfahren
Elément d'image et procédé de fabrication de plaques d'impression lithographiques suivant le procédé de diffusion-transfert de sel d'argent

(43) Date of publication of application: 21.06.1995
(73) Proprietor: AGFA-GEVAERT N.V., 2640 Mortsel (BE)
(72) Inventor: Coppens, Paul c/o Agfa-Gevaert N.V.,, B-2640 Mortsel (BE); Hoes, Eric c/o Agfa-Gevaert N.V.,, B-2640 Mortsel (BE)

(56) References cited:
- EP-A- 0 474 922
- EP-A- 0 483 415
- EP-A- 0 564 020
- PATENT ABSTRACTS OF JAPAN vol. 8, no. 31 (P-253)(1468) 9 February 1984 & JP-A-58 184 151 (KONISHIROKU SHASHIN KOGYO) 27 October 1983

## Description

### 1. Field of the invention.

The present invention relates to an imaging element for making improved offset printing plates according to the silver salt diffusion transfer process. Furthermore the present invention relates to a method for making improved offset printing plates with said imaging element.

### 2. Background of the invention.

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image receiving layer and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellant ink-receptive areas on a water-receptive ink-repellant background. The DTR-image can be formed in the image receiving layer of a sheet or web material which is a separate element with respect to the photographic silver halide emulsion material (a so-called two-sheet DTR element) or in the image receiving layer of a so-called single-support-element, also called mono-sheet element, which contains at least one photographic silver halide emulsion layer integral with an image receiving layer in waterpermeable relationship therewith. It is the latter mono-sheet version which is preferred for the preparation of offset printing plates by the DTR method.

Two types of the mono-sheet DTR offset printing plate exist. According to a first type disclosed in e.g. US-P-4,722,535 and GB-1,241,661 a support is provided in the order given with a silver halide emulsion layer and a layer containing physical development nuclei serving as the image-receiving layer. After information-wise exposure and development the imaged element is used as a printing plate without the removal of the emulsion layer. This type of printing plates has a low printing endurance, typically around 10000 copies.

According to a second type of mono-sheet DTR offset printing plate a hydrophilic support, mostly anodized aluminium, is provided in the order given with a layer of physical development nuclei and a silver halide emulsion layer. After information-wise exposure and development the imaged element is treated to remove the emulsion layer so that a support carrying a silver image is left wich is used as a printing plate. This type of printing plates has a much higher printing endurance, typically at least 25000 copies. Such type of lithographic printing plates is disclosed e.g. in US-P-3,511,656, EP-A-278766, EP-A-410500 and EP-A-483415.

As for other printing plates it is required that the offset printing plates belonging to the second type of mono-sheet DTR offset printing plates have good printing properties. However these plates give copies which show a high number of white spots in the printing areas. Furthermore the process by which the printing plate is obtained should be an easy, ecological and ergonomical one. Yet, removing the emulsion layer by treating the developed imaging element with an aqueous solution, what is the most usual procedure, causes a cumbersome excessive foaming of a very stable nature, due to the dissolution in the aqueous solution of the surfactants which are used in the preparation of the imaging element in order to get a homogeneous spreading of the layers on each other.

### 3. Summary of the invention.

It is an object of the present invention to provide an imaging element for making offset printing plates according to the silver salt diffusion transfer process with good printing quality and ergonomical processing.

It is another object of the present invention to provide a method for making offset printing plates with said imaging element having good printing quality and ergonomical processing.

Further objects of the present invention will become clear from the description hereinafter.

According to the present invention there is provided an imaging element comprising in the order given (i) a hydrophilic base, (ii) an image receiving layer containing physical development nuclei, (iii) a photosensitive layer containing a silver halide emulsion being in water permeable relationship with said image receiving layer and (iv) optionally an intermediate layer between said image receiving layer and said photosensitive layer, said intermediate layer comprising a non-proteinic hydrophilic film-forming polymer or hydrophobic polymer beads having an average diameter not lower than 0.2 µm and having been prepared by polymerization of a ethylenically unsaturated monomer, characterized in that at least one layer contains at least one fluorine containing surfactant.

According to the present invention there is also provided a method for making an offset printing plate according to the silver salt diffusion transfer process by a more ergonomical processing comprising the steps of:
(a) image-wise exposing an imaging element according to the present invention,
(b) applying an aqueous alkaline solution to the imaging element in the presence of (a) developing agent(s) and (a) silver halide solvent(s) to form a silver image in said photosensitive layer and to allow unreduced silver halide or complexes formed thereof to diffuse image-wise from the photosensitive layer to said image receiving layer to produce therein a silver image,
(c) treating the imaging element to remove the layer(s) on top of said image receiving layer, thereby uncovering said silver image formed in said image receiving layer.

### 4. Detailed description of the invention.

According to the present invention it has been found that a lithographic printing plate obtained according to the DTR-process by using an imaging element comprising fluorine containing surfactant produces prints with almost no white spots in the printing areas and whereof the preparation proceeds without excessive foaming as would be the case when using an imaging element containing classical surfactants.

Preferably, the fluorine containing surfactants are surfactants with a C₆-C₁₀ perfluorinated alkyl group. More preferably said perfluorinated alkyl surfactants are of the nonionic and most preferably of the anionic type.

Representatives of said perfluorinated alkyl surfactants are listed in Table 1.

**Table 1**

| Cpd | Chemical structure | Commercial name |
|---|---|---|
| 1 | n.C₈F₁₇SO₃NH₂(C₂H₄OH)₂ | Fluorad FC 99 from 3M |
| 2 | n.C₁₀F₂₁SO₃NH₄ | Fluorad FC 120 from 3M |
| 3 | n.C₇F₁₅CO₂NH₄ | Fluorad FC 126 from 3M |
| 4 | n.C₈F₁₇SO₂N(C₂H₅)(CH₂CO₂K | Fluorad FC 129 from 3M |
| 5 | n.C₈F₁₇SO₂N(C₂H₅)(C₂H₄O)₄₋₇H | Fluorad FC 170c from 3M |
| 6 | n.C₈F₁₇SO₂N(C₂H₅)(C₂H₄O)₄₋₇CH₃ | Fluorad FC 171c from 3M |
| 7 | n.C₉F₁₉SO₃K | |
| 8 | n.C₈F₁₇SO₂NHCH₂CO₂K | FT 178 from Bayer |
| 9 | n.C₈F₁₇SO₂NCH₃CO₂(C₂H₄O)₁₉C₄H₉ | FT 179 from Bayer |
| 10 | n.C₈F₁₇SO₃Li | FT 208 from Bayer |
| 11 | n.C₈F₁₇SO₃N(C₂H₅)₄ | FT 248 from Bayer |
| 12 | n.C₇F₁₅CONH(C₂H₄O)₁₇H | |

According to the invention at least one layer contains at least one fluorine containing surfactant. The fluorine containing surfactant can be comprised in any layer of the imaging element. the photosensitive layer and/or in any other layer being in water permeable relationship with the photosensitive layer. Preferably, at least the photosensitive layer and/or the optional barrier layer contains at least one fluorine containing surfactant.
Although all surfactants contained in the imaging element can be fluorine containing surfactants, preferably said imaging element comprises at least one non-fluorine containing surfactant in addition to the fluorine containing surfactant(s) wether or not in the same layer(s) for various reasons e.g. a better spreading of the coatings, less electrostatic effects.

The fluorine containing surfactant can be used in a very broad concentration range. Preferably, the concentration of the fluorine containing surfactant in a layer is comprised between 0.05 % and 20 % by weight versus the total dry weight of the layer. More preferably, the concentration of the fluorine containing surfactant in a layer is comprised between 0.2 % and 15 % by weight versus the total dry weight of the layer.

The imaging element is preferably prepared by coating the different layers on a hydrophilic base. Alternatively the different layers may be laminated to said image receiving layer from a temporary base holding the layers in reverse order as disclosed in US-P 5,213,943.

The hydrophilic base can be a hardened hydrophilic layer, containing a hydrophilic synthetic homopolymer or copolymer and a hardening agent coated on a flexible support. Preferred hydrophilic layers are layers of polyvinyl alcohol hardened with a tetraalkyl orthosilicate and preferably containing SiO₂ and/or TiO₂ wherein the weight ratio between said polyvinylalcohol and said tetraalkyl orthosilicate is between 0.5 and 5 as disclosed in e.g. GB-P 1,419,512, FR-P 2,300,354, US-P-3,971,660, US-P 4,284,705, EP-A 405,016 and EP-A 450,199 which therefor are incorporated herein by reference.

More preferably an aluminium support is used as a hydrophilic base.

The aluminium support of the imaging element for use in accordance with the present invention can be made of pure aluminium or of an aluminium alloy, the aluminium content of which is at least 95%. The thickness of the support usually ranges from about 0.13 to about 0.50 mm.

The preparation of aluminium or aluminium alloy foils for lithographic offset printing comprises the following steps : graining, anodizing, and optionally sealing of the foil.

Graining and anodization of the foil are necessary to obtain a lithographic printing plate that allows to produce high-quality prints in accordance with the present invention. Sealing is not necessary but may still improve the printing results. Preferably the aluminium foil has a roughness with a CLA value between 0.2 and 1.5 µm, an anodization layer with a thickness between 0.4 and 2.0 µm and is sealed with an aqueous bicarbonate solution.

The graining, anodizing, and sealing of the aluminium foil can be performed as described in e.g. in U.S. Serial No. 08/035,965, US-P-3,861,917 and in the documents referred to therein.

To promote the image sharpness and, as a consequence thereof, the sharpness of the final printed copy, the anodization layer may be coloured in the mass with an antihalation dye or pigment e.g. as described in JA-Pu-58-14,797.

Subsequent to the preparation of the hydrophilic base as described above the hydrophilic base may be immediately coated with a solution containing the physical development nuclei or may be coated with said solution at a later stage.

The image receiving layer for use in accordance with the present invention is preferably free of hydrophilic binder but may comprise small amounts up to 30% by weight of the total weight of said layer of a hydrophilic colloid e.g. polyvinyl alcohol to improve the hydrophilicity of the layer.

Preferred development nuclei for use in accordance with the present invention are sulphides of heavy metals e.g. sulphides of antimony, bismuth, cadmium, cobalt, lead, nickel, palladium, platinum, silver, and zinc. Other suitable development nuclei are heavy metal salts such as e.g. selenides, polyselenides, polysulphides, mercaptans, and tin (II) halides. Heavy metals, preferably silver, gold, platinum, palladium, and mercury can be used in colloidal form. More preferred development nuclei for use in accordance with the present invention are nuclei, especially sulphides of heavy metals having an average diameter less than 6 nm and wherein the number of nuclei having a diameter larger than 4.5 nm is less than 15% of the total number of nuclei contained in said image receiving layer as disclosed in U.S. Serial No. 07/979,897. Especially preferred development nuclei in connection with the present invention are palladium sulphide nuclei having an average diameter less than 6 nm and wherein the number of nuclei having a diameter larger than 4.5 nm is less than 15% of the total number of nuclei contained in said image receiving layer.

To promote the image sharpness the hydrophilic base can be provided with a very thin antihalation coating of a dye or pigment or the image receiving layer may incorporate at least one antihalation dye or pigment.

The photosensitive layer used in accordance with the present invention may be any silver halide emulsion layer comprising a hydrophilic colloid binder, at least one of the silver halide emulsions being photosensitive.

The photographic silver halide emulsion(s) for coating silver halide emulsion layers in accordance with the present invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

For use according to the present invention the silver halide emulsion or emulsions preferably consist principally of silver chloride while a fraction of silver bromide may be present ranging from 1 mole % to 40 mole %. Most preferably a silver halide emulsion containing at least 70 mole% of silver chloride is used.

The average size of the silver halide grains may range from 0.10 to 0.70 µm , preferably from 0.25 to 0.45 µm.

Preferably during the precipitation stage iridium and/or rhodium containing compounds or a mixture of both are added. The concentration of these added compounds ranges from 10⁻⁸ to 10⁻³ mole per mole of AgNO₃, preferably between 10⁻⁷ and 10⁻⁶ mole per mole of AgNO₃.

The silver halide emulsions can be chemically sensitized. A method of chemical sensitization has been described in the article of R.KOSLOWSKY, Z. Wiss. Photogr. Photophys. Photochem. 46, 65-72 (1951).

The silver halide emulsions of the DTR-element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons.

The spectral photosensitivity of the silver halide can also be adjusted for exposure by laser light e.g. helium-neon laser light, argon laser light, and solid state laser light. Dyes that can be used for adjusting the photosensitivity to laser light have been disclosed i.a. in the documents cited in EP-A-93200339.5 and US-P-5,200,294.

The silver halide emulsions may contain the usual emulsion stabilizers. Suitable emulsion stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable emulsion stabilizers are i.a. heterocyclic mercapto compounds.

As binder in the silver halide emulsion layer(s) in connection with the present invention a hydrophilic colloid may be used, usually a protein, preferably gelatin. Gelatin can, however, be replaced in part or integrally by synthetic, semi-synthetic, or natural polymers. Preferably the silver halide emulsion layer contains at least one gelatin species whereof a 10 % by weight aqueous solution at 36 °C and pH 6 has a viscosity lower than 20 mPa.s at a shearing rate of 1000 s⁻¹ combined with a gelatin of a higher viscosity. The weight ratio of said low viscosity gelatin versus the gelatin of a higher viscosity is preferably > 0.5.

Preferably the gelatin layer(s) is(are) substantially unhardened. Substantially unhardened means that when such gelatin layer is coated on a subbed polyethylene terephtalate film base at a dry thickness of 1.2 g/m², dried for 3 days at 57 C° and 35% R.H. and dipped in water of 30 C°, said gelatin layer is dissolved for >95 % by weight within 5 minutes.

The silver halide emulsions may contain pH controlling ingredients. Preferably the silver halide emulsion layer is coated at a pH value below the isoelectric point of the gelatin to improve the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P-4,092,168, US-P-4,311,787, DE-P-2,453,217.

More details about the composition, preparation and coating of silver halide emulsions suitable for use in accordance with the present invention can be found in e.g. Product Licensing Index, Vol. 92, December 1971, publication 9232, p. 107-109.

The imaging element preferably also comprises an intermediate layer between the image receiving layer on the hydrophilic base and the photosensitive layer(packet) to facilate the removal of said layer(packet) thereby uncovering the silver image formed in the image receiving layer by processing the imaging element.

In one embodiment, the intermediate layer is a water-swellable intermediate layer coated at a ratio of 0.01 to 2.0 g/m2 and comprising at least one non-proteinic hydrophilic film-forming polymer and optionally comprising an antihalation dye or pigment as disclosed in EP-A-410500.

In another embodiment, the intermediate layer is a layer comprising hydrophobic polymer beads having an average diameter not lower than 0.2 µm and having been prepared by polymerization of at least one ethylenically unsaturated monomer. Preferably, said intermediate layer in dry condition comprises said hydrophobic polymer beads in an amount of up to 80% of its total weight. Further details are disclosed in EP-A-483415.

A supplemental intermediate layer, which may be present between said silver halide emulsion containing layer and said water-swellable intermediate layer or said intermediate layer comprising hydrophobic polymer beads may incorporate one or more ingredients such as i.a. antihalation dyes or pigment, developing agents, silver halide solvents, base precursors, and anticorrosion substances.

When the imaging element is prepared by laminating a photosensitive layer or layer packet onto the image receiving layer the intermediate layer(s) are contained in the photosensitive layer packet, the water-swellable intermediate layer or the intermediate layer comprising hydrophobic polymer beads having an average diameter not lower than 0.2 µm and having been prepared by polymerization of at least one ethylenically unsaturated monomer being the upper layer.

A wide choice of cameras for exposing the photosensitive silver halide emulsion exists on the market. Horizontal, vertical and darkroom type cameras and contact-exposure apparatus are available to suit any particular class of reprographic work. The imaging element can also be exposed with the aid of i.a. laser recorders and cathode rays tubes.

The development and diffusion transfer are effected with the aid of an aqueous alkaline solution in the presence of (a) developing agent(s) and (a) silver halide solvent(s). The developing agent(s) and/or the silver halide solvent(s) can be incorporated in the aqueous alkaline solution and/or in said silver halide emulsion layer and/or in any of said intermediate layers and/or in a supplemental hydrophilic colloid layer in water-permeable relationship with said silver halide emulsion layer. The latter supplemental hydrophilic colloid layer can be coated on top of said silver halide emulsion layer remotest from said hydrophilic base.

The silver halide solvent can also be incorporated at least in part in the physical development nuclei containing layer. When the aqueous alkaline solution does not comprise the developing agent(s), it is merely an activating liquid that is capable of dissolving the developing agent(s) contained in one of the layers.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. More details are disclosed in EP-A-93201649.6. However other developing agents can be used. Preferred amounts of the hydroquinone-type developing agents are in the range of 0.05 mole to 0.25 mole per litre and preferred amounts of secondary developing agent(s) in the range of 1.8 x 10⁻³ to 2.0 x 10⁻² mole per litre.

The silver halide solvent, which acts as a complexing agent for silver halide, preferably is a water-soluble thiosulphate or thiocyanate e.g. sodium, potassium, or ammonium thiosulphate and sodium, potassium, or ammonium thiocyanate.

Further silver halide solvents that can be used in connection with the present invention are alkanolamines. Alkanolamines that are suitable for use in accordance with the present invention may be of the tertiary, secundary or primary type. Examples of alkanolamines that may be used in connection with the present invention are disclosed in e.g. U.S. Serial No. 07/810,146.

The alkanolamines are preferably present in the alkaline processing liquid in a concentration preferably between 0.05% and 10% by weight. However part or all of the alkanolamine can be present in one or more layers of the imaging element.

Further suitable silver halide solvents are thioethers. Preferably used thioethers are disclosed in e.g. US-P-4,960,683 and US-P-5,200,294.

Still further suitable silver halide solvents are meso-ionic compounds. Preferred meso-ionic compounds for use in accordance with the present invention are triazolium thiolates and more preferably 1,2,4-triazolium-3-thiolates. More details are disclosed in US-Serial No. 07/986,071

Still further suitable silver halide solvents are sulphite, amines, 2-mercaptobenzoic acid and those disclosed in "The Theory of the Photographic Process" 4th Ed., edited by T.H.James, pages 474-475. Further interesting silver halide solvents have been described in i.a. US-P-2,857,276, 4,355,090, 4,297,429 and 4,297,430. Among these are cyclic imide compounds such as e.g. uracil and 5,5-dialkylhydantoins. Other suitable silver halide solvents are the alkyl sulfones.

Combinations of different silver halide solvents can be used and it is also possible to incorporate at least one silver halide solvent into a suitable layer of the imaging element and to add at least one other silver halide solvent to the developing solution.

Examples of suitable combinations of different silver halide solvents are a combination of (an) alkanolamine(s) and a thiosulfate as disclosed in U.S. Serial No. 07/810,151 and 4,6-dihydroxypyrimidines in combination with other silver halide solvents as disclosed in U.S. Serial No. 07/810,146.

The aqueous alkaline solution may further comprise sulphite e.g. sodium sulphite in an amount ranging from 40 g to 180 g per litre, preferably from 60 to 160 g per litre, and a silver halide solvent, preferably a water soluble thiosulphate and/or thiocyanate in an amount ranging from 5 g to 20 g per litre.

Examples of other suitable combinations of different silver halide solvents are combinations of a meso-ionic compound and another silver halide solvent as disclosed in US-Serial No. 07/986,071.

Combinations of at least one silver halide solvent and a regulator may also be used. Suitable regulators are disclosed in U.S. Serial No. 07/986,072 and in EP-A-92201997.1.

The aqueous alkaline solution used according to the present invention preferably comprises aluminium ions in an amount of at least 0.3 g/l in order to prevent sticking of the emulsion layer to the transporting rollers when the emulsion is swollen with the aqueous alkaline solution. More preferably the aqueous alkaline solution used in accordance with the present invention comprises aluminium ions in an amount of at least 0.6 g/l.

The alkaline processing liquid preferably has a pH between 9 and 14 and more preferably between 10 and 13. Said pH be established by an organic or inorganic alkaline substance or a combination thereof. Suitable inorganic alkaline substances are e.g. potassium or sodium hydroxide, carbonate, phosphate. Suitable organic alkaline substances are e.g. alkanolamines. In the latter case the alkenolamines will provide or help providing the pH and serve as a silver halide complexing agent.

The processing conditions such as pH, temperature and time may vary within broad ranges provided the mechanical strength of the materials to be processed is not adversely influenced and no decomposition takes place.

The aqueous alkaline solution may further comprise hydrophobizing agents for improving the hydrophobicity of the silver image obtained in the image image receiving layer. Generally these compounds contain a mercapto group or thiolate group and one or more hydrophobic substituents. Examples of hydrophobizing agents are e.g. those described in US-P-3,776,728, and US-P-4,563,410. Particularly preferred hydrophobizing agents are long chain (at least 5 carbon atoms) alkyl substituted mercaptotetrazoles. More details are disclosed in EP-A-93201649.6. The hydrophobizing agents can be used alone or in combination with each other.

The aqueous alkaline solution preferably also comprises oxidation preservatives, a compound releasing bromide ions, calcium-sequestering compounds e.g. EDTA or its sodium salt, thickening agents e.g. cellulose or its derivatives such as carboxymethylcellulose and anti-sludge agents.

Regeneration of the aqueous alkaline solution according to known methods is, of course, possible, whether the solution incorporates developing agent(s) and/or silver halide solvent(s) or not.

The development may be stopped - though this is often not necessary - with a so-called stabilization liquid, which actually is an acidic stop-bath having a pH preferably in the range of 5 to 6 as disclosed in EP-A-519,123.

The development and diffusion transfer can be initiated in different ways e.g. by rubbing with a roller, by wiping with an absorbent means e.g. with a plug of cotton or sponge, or by dipping the material to be treated in the liquid composition. Preferably, they proceed in an automatically operated apparatus. They are normally carried out at a temperature in the range of 18°C to 30°C.

After formation of the silver image on the lithographic image receiving element an excess of alkaline solution still present on the monosheet layer assemblage may be eliminated, preferably by guiding the monosheet layer assemblage through a pair of squeezing rollers.

The silver image thus obtained in the image receiving layer is subsequently uncovered by treating the imaging element to remove the photosensitive layer and the intermediate layer.

According to a particularly preferred embodiment for removing the photosensitive layer(s) and the intermediate layer(s) the imaging element is held under a spray or jet of rinsing water or rinsing aqueous medium. The rinsing aqueous medium used to detach the intermediate layer(s) and the emulsion layer(s)(s) by rinsing may comprise ingredients such as i.a. wetting agents, and hardeners including latent hardeners.

The temperature of the rinsing water may be varied widely but is preferably between 20°C and 45°C.

The imaged surface of the lithographic base can be subjected to a chemical treatment that increases the hydrophilicity of the non-silver image parts and the oleophilicity of the silver image.

This chemical after-treatment is preferably carried out with a lithographic composition often called fixer, which comprises at least one compound enhancing the ink-receptivity and/or lacquer-receptivity of the silver image, and also comprises at least one compound that improves the ink-repelling characteristics of the hydrophilic grained and anodized aluminium support. Examples of said compounds enhancing the ink-receptivity are disclosed in e.g. US-P 3,776,728, US-P 4,563,410 and EP-A-93201878.1 which therefor are incorporated herein by reference. Preferably, said composition also comprises a surfactant, more preferably a surfactant comprising a poly-ethyleneoxide group, most preferably a surfactant comprising a poly-ethyleneoxide chain comprising an acidic function e.g. GEBO, marketed by Chemische Fabrik Chem-Y, Gmbh, Germany.

At the moment the treatment with the fixer is started the surface carrying the silver pattern may be in dry or wet state. In general, the treatment with the fixer does not take long, usually not longer than about 30 seconds and it may be carried out immediately after the processing and uncovering steps.

The fixer can be applied in different ways such as by rubbing with a roller, by wiping with an absorbent means e.g. with a plug of cotton or sponge, or by dipping the material to be treated in the fixer. The image-hydrophobizing step of the printing plate may also proceed automatically by conducting the printing plate through a device having a narrow channel filled with the fixer and conveying the printing plate at the end of the channel between two squeezing rollers removing the excess of liquid.

The following example illustrates the present invention without however, limiting it thereto. All parts, percentages and ratios are by weight unless otherwise indicated.

### EXAMPLE 1 ( Comparative example)

An imaging element I was obtained by coating a grained, anodized and sealed aluminium support with a silver-receptive stratum containing 0.7 mg/m² PdS as physical development nuclei.

An intermediate layer was then provided on the dry silver-receptive stratum from an aqueous composition in such a way that the resulting dried layer had a weight of 0.5 g of polymethyl methacrylate beads per m², said composition comprising:

| | |
|---|---|
| a 20 % dispersion of polymethyl methacrylate beads in a mixture of equal volumes of water and ethanol having an average diameter of 1.0 µm | 50 ml |
| Helioechtpapierrot BL (trade mark for a dye sold by BAYER AG, D-5090 Leverkusen, West-Germany) | 2.5 g |
| saponine | 3.5 g |
| GEBO ( trade mark for a surfactant sold by Chemische Fabrik Chem-Y, Gmbh, Germany) | 1.25 g |
| TERGO ( trade mark for a surfactant sold by Chemische Fabrik Chem-Y, Gmbh, Germany) | 0.2 g |
| Saponine | 3.5 g |
| demineralized water | 300 ml |
| (pH-value : 5.6) | |

Finally a substantially unhardened photosensitive negative-working cadmium-free gelatin silver chlorobromoiodide emulsion layer (97.98 / 2 / 0.02 mol%) was provided on the intermediate layer, the silver halide being provided in an amount corresponding to 2.40 g of silver nitrate per m², the gelatin content of the emulsion layer being 0.58 g/m² of ROUSSELOT T10985 (marketed by Rousselot S.A., France) and 1 g/m² of KOEPF T7598 (marketed by Koepf A.G., Germany.) and the saponine content of the emulsion layer being 0.02 g/m².

Imaging elements II to V were prepared in an identical way except that the surfactant composition in the intermediate layer was adapted as indicated in table 1.

**Table 2**

| No^{a)} | GEBO^{b)} | Saponine | TERGO^{c)} | Cpd 12^{d)} | Cpd 11^{e)} |
|---|---|---|---|---|---|
| I | 1.25 g | 3.5 g | 0.2 g | - | |
| II | 1.25 g | 3.5 g | - | - | 0.2 g |
| III | 1.25 g | 1.5 g | - | - | 0.2 g |
| IV | 1.25 g | 1.5 g | - | - | 0.5 g |
| V | 1.25 g | 1.5 g | - | 1 g | - |

| | | | | | |
|---|---|---|---|---|---|
| -a) No : the number of the imaging element. | | | | | |
| -b) GEBO : trade mark for a surfactant sold by Chemische Fabrik Chem-Y, Gmbh, Germany with as formula: (CH₃)₃-CH₂-C(CH₃)₂-p.-C₆H₄-(CH₂-CH₂-O)₁₄₋₁₈-CH₂-COOH. | | | | | |
| -c) TERGO : trade mark for a surfactant sold by Chemische Fabrik Chem-Y, Gmbh, Germany with as formula: (C₂H₅) (C₄H₉)CH-C₂H₄-(C₄H₉)CH-OSO₃Na | | | | | |
| -d) Cpd 12 : Cpd 12 of table 1. | | | | | |
| -d) Cpd 11 : Cpd 11 of table 1. | | | | | |

Those 5 imaging elements were identically exposed through a step wedge in a process-camera and immersed for 8 s at 24°C in a freshly made developing solution having the following ingredients:

| | |
|---|---|
| carboxymethylcellulose | 4 g |
| sodium hydroxide | 22.5 g |
| anhydrous sodium sulphite | 120 g |
| hydroquinone | 20 g |
| 1-phenyl-3-pyrazolidinone | 6 g |
| potassium bromide | 0.75 g |
| anhydrous sodium thiosulphate | 8 g |
| ethylene diamine tetraacetic acid tetrasodium salt | 2 g |
| demineralized water to make | 1000 ml |
| pH (24°C) = 13 | |

The initiated diffusion transfer was allowed to continue for 30 s to form a silver image in the image receiving layers.

To remove the developed silver halide emulsion layer and the intermediate layer from the aluminium foils the developed monosheet DTR materials were rinsed for 30 s with a water jet at 20°C. The washwater is collected in a washwater tank and used again for providing the water to the water jet.

Next, the imaged surface of the aluminium foil was rubbed with a fixer to enhance the water-receptivity of the non-image areas and to make the image areas oleophilic ink-receptive. The fixer had the following composition :

| | |
|---|---|
| Gebo ( trade mark for a surfactant sold by Chemische Fabrik Chem-Y, Gmbh, Germany) | 100 mg |
| 20% aqueous solution of polystyrene sulphonic acid | 100 ml |
| potassium nitrate | 12.5 g |
| citric acid | 20.0 g |
| 1-phenyl-5-mercaptotetrazole | 2.0 g |
| sodium hydroxide | 5.5 g |
| water to make | 1000 ml |
| pH (20°C) = 4 | |

The printing plates thus prepared were mounted on the same offset printing machine (HEIDELBERG GTO-46) and were used for printing under identical conditions. Commercial AQUA TAME 7035E, marketed by Anchor/Lithemko Inc., Florida, was used at a 5 % concentration in an aqueous solution containing 10 % isopropanol as dampening solution and K+E 125, marketed by Kast+Ehinger, A.G., Germany, as ink. A compressible rubber blanket was used.

The results are given in the following Table 3.

**Table 3**

| Sample^{a)} | White spots in printing area^{b)} | | | Foam^{c)} |
|---|---|---|---|---|
| | K2 | K3 | Total | |
| I | 0 | 35 | 35 | > 0.3 m |
| II | 0 | 4 | 4 | 0.15 m |
| III | 0 | 0 | 0 | 0.10 m |
| IV | 0 | 0 | 0 | 0.12 m |
| V | 8 | 0 | 8 | 0.15 m |

| | | | | |
|---|---|---|---|---|
| -a) : The original imaging element referred to in table 2. | | | | |
| -b) : The number of white spots/ m² of printed areas was visually counted. The magnitude of the white spots is expressed on a relative scale from K1 to K3, where K1 stands for a white spot with a diameter < 0.1 mm, K2 stands for a white spot with a diameter between 0.1 mm and 0.5 mm and K3 stands for a white spot with a diameter between 0.5 mm and 1 mm. | | | | |
| -c) : The height of the foam in the washwater tank is measured after a continuous processing of 15 m² of imaging material. | | | | |

### Evaluation:

From the above it can be seen that a printing plate obtained according to the silver salt diffusion transfer process using the imaging element I (comparison) produces copies with a high number of white spots in the printed areas while a printing plate obtained using one of the imaging elements II to V (in accordance with the present invention) produces copies with none or a low number of white spots in the printed areas. Furthermore the height of the foam in the washwater tank is high when processing the imaging element I, but is drastically lower when processing the imaging elements II to V.

## Claims

1. An imaging element comprising in the order given (i) a hydrophilic base, (ii) an image receiving layer containing physical development nuclei, (iii) a photosensitive layer containing a silver halide emulsion being in water permeable relationship with said image receiving layer and (iv) optionally an intermediate layer between said image receiving layer and said photosensitive layer, said intermediate layer comprising a non-proteinic hydrophilic film-forming polymer or hydrophobic polymer beads having an average diameter not lower than 0.2 µm and having been prepared by polymerization of a ethylenically unsaturated monomer, characterized in that at least one layer contains at least one fluorine containing surfactant.

2. An imaging element according to claim 1 wherein said fluorine containing surfactant is a surfactant with a C₆-C₁₀ perfluorinated alkyl group.

3. An imaging element according to claim 2, wherein said surfactant with a C₆-C₁₀ perfluorinated alkyl group is of the nonionic or of the anionic type.

4. An imaging element according to any of claims 1 to 3, wherein the concentration of the fluorine containing surfactant in a layer is comprised between 0.2 % and 15 % by weight versus the total dry weight of the layer.

5. An imaging element according to any of claims 1 to 4, wherein at least said photosensitive layer and/or said optional intermediate layer contains at least one fluorine containing surfactant.

6. An imaging element according to any of claims 1 to 5, comprising at least one layer containing at least one non-fluorine containing surfactant, said layer comprising either or not at least one fluorine containing surfactant.

7. A method for the preparation of an offset printing plate according to the silver salt diffusion transfer process comprising the steps of:
(a) image-wise exposing an imaging element according to any of claims 1 to 6,
(b) applying an aqueous alkaline solution to the imaging element in the presence of (a) developing agent(s) and (a) silver halide solvent(s) to form a silver image in said photosensitive layer and to allow unreduced silver halide or complexes formed thereof to diffuse image-wise from the photosensitive layer to said image receiving layer to produce therein a silver image,
(c) treating the imaging element to remove the layer(s) on top of said image receiving layer, thereby uncovering said silver image formed in said image receiving layer.

## Patentansprüche

1. Ein bilderzeugendes Element, das der angegebenen Reihe nach (i) einen hydrophilen Träger, (ii) eine physikalische Entwicklungskeime enthaltende Bildempfangsschicht, (iii) eine lichtempfindliche Schicht mit einer Silberhalogenidemulsion in wasserdurchlässiger Beziehung zur Bildempfangsschicht und (iv) gegebenenfalls eine zwischen der Bildempfangsschicht und der lichtempfindlichen Schicht eingearbeitete Zwischenschicht enthält, wobei die Zwischenschicht ein nicht-proteinhaltiges hydrophiles filmbildendes Polymeres oder hydrophobe polymere Perlen mit einem mittleren Durchmesser von wenigstens 0,2 µm enthält, die durch Polymerisation eines ethylenisch ungesättigten Monomeren erhalten sind, dadurch gekennzeichnet, daß wenigstens eine Schicht wenigstens ein fluorhaltiges Tensid enthält.

2. Bilderzeugendes Element nach Anspruch 1, dadurch gekennzeichnet, daß das fluorhaltige Tensid ein Tensid mit einer C₆-C₁₀-Perfluoralkylgruppe ist.

3. Bilderzeugendes Element nach Anspruch 2, dadurch gekennzeichnet, daß das Tensid mit einer C₆-C₁₀-Perfluoralkylgruppe des nicht-ionischen oder anionischen Typs ist.

4. Bilderzeugendes Element nach irgendeinem der Ansprüche 1 bis 3, dadurch gekennzeichnet, daß das Verhältnis des fluorhaltigen Tensids in einer Schicht zwischen 0,2 Gew.-% und 15 Gew.-%, bezogen auf das Gesamttrockengewicht der Schicht, liegt.

5. Bilderzeugendes Element nach irgendeinem der Ansprüche 1 bis 4, dadurch gekennzeichnet, daß wenigstens die lichtempfindliche Schicht und/oder die gegebenenfalls angebrachte Zwischenschicht wenigstens ein fluorhaltiges Tensid enthalten.

6. Bilderzeugendes Element nach irgendeinem der Ansprüche 1 bis 5, das wenigstens eine Schicht mit wenigstens einem nichtfluorhaltigen Tensid enthält, wobei diese Schicht gegebenenfalls wenigstens ein fluorhaltiges Tensid enthält.

7. Ein Verfahren zur Herstellung einer Offsetdruckplatte nach dem Silbersalz-Diffusionsübertragungsverfahren, das folgende Stufen umfaßt :
(a) die bildmäßige Belichtung eines bilderzeugenden Elements nach irgendeinem der Ansprüche 1 bis 6,
(b) den Auftrag einer wäßrigen alkalischen Lösung auf das bilderzeugende Element in Gegenwart einer oder mehrerer Entwicklersubstanzen und eines oder mehrerer Silberhalogenid-Lösungsmittel, wodurch in der lichtempfindlichen Schicht ein Silberbild erzeugt wird und nicht-reduziertes Silberhalogenid oder dessen daraus gebildete Komplexe von der lichtempfindlichen Schicht zur Bildempfangsschicht überdiffundieren können, um darin ein Silberbild zu erzeugen,
(c) die Verarbeitung des bilderzeugenden Elements zur Entfernung der auf der Bildempfangsschicht befindlichen Schicht(en), wodurch das in der Bildempfangsschicht erzeugte Silberbild aufgedeckt wird.

## Revendications

1. Elément de formation d'image comprenant, dans l'ordre donné, (i) une base hydrophile, (ii) une couche de réception d'image contenant des germes de développement physique, (iii) une couche photosensible contenant une émulsion à l'halogénure d'argent en relation de perméabilité à l'eau avec ladite couche de réception d'image et (iv), le cas échéant, une couche intermédiaire entre ladite couche de réception d'image et ladite couche photosensible, ladite couche intermédiaire comprenant un polymère filmogène hydrophile non protéinique ou des perles de polymères hydrophobes possédant un diamètre moyen qui n'est pas inférieur à 0,2 µm et que l'on prépare par polymérisation d'un monomère à insaturation éthylénique, caractérisé en ce qu'au moins une couche contient au moins un agent tensioactif fluoré.

2. Elément de formations d'image selon la revendication 1, dans lequel ledit agent tensioactif fluoré est un agent tensioactif contenant un groupe alkyle perfluoré en C₆-C₁₀.

3. Elément de formation d'image selon la revendication 2, dans lequel ledit agent tensioactif contenant un groupe alkyle perfluoré en C₆-C₁₀ est du type non ionique ou du type anionique.

4. Elément de formation d'image selon l'une quelconque des revendications 1 à 3, dans lequel la concentration de l'agent tensioactif fluoré dans une couche est comprise entre 0,2% et 15% en poids par rapport au poids total à sec de la couche.

5. Elément de formation d'image selon l'une quelconque des revendications 1 à 4, dans lequel au moins ladite couche photosensible et/ou ladite couche intermédiaire facultative contient au moins un agent tensioactif fluoré.

6. Elément de formation d'image selon l'une quelconque des revendications 1 à 5, comprenant au moins une couche contenant au moins un agent tensioactif non fluoré, ladite couche comprenant, le cas échéant, au moins un agent tensioactif fluoré.

7. Procédé pour la préparation d'un cliché d'impression offset conformément au procédé de transfert de sels d'argent par diffusion comprenant les étapes consistant à :
(a) exposer en forme d'image un élément de formation d'image selon l'une quelconque des revendications 1 à 6,
(b) appliquer une solution alcaline aqueuse sur l'élément de formation d'image en présence d'un ou de plusieurs agents développateurs et d'un ou de plusieurs solvants de l'halogénure d'argent pour former une image argentique dans ladite couche photosensible pour permettre à l'halogénure d'argent non réduit ou à des complexes formés à partir de ce dernier de diffuser en forme d'image de la couche photosensible à ladite couche de réception d'image pour y produire une image argentique,
(c) traiter l'élément de formation d'image pour éliminer la ou les couches par-dessus ladite couche de réception d'image et ainsi mettre à nu ladite image argentique formée dans ladite couche de réception d'image.
